# EUROPEAN PATENT APPLICATION

(11) **EP 4 414 170 A1**
(43) Date of publication of application: **14.08.2024**
(21) Application number: 22878574.7
(22) Date of filing: 06.10.2022
(51) Int. Cl.: B32B 18/00, C23C 14/06, H01L 21/20, H01L 21/203

(54) **LAMINATE AND METHOD FOR MANUFACTURING SAME**

(30) Priority: 08.10.2021 JP 2021166428
(71) Applicant: Tosoh Corporation, Yamaguchi 746-8501 (JP); National Institute for Materials Science, Tsukuba-shi, Ibaraki 305-0047 (JP)
(72) Inventor: SUEMOTO, Yuya, Ayase-Shi, Kanagawa 252-1123 (JP); UEOKA, Yoshihiro, Ayase-Shi, Kanagawa 252-1123 (JP); MESUDA, Masami, Ayase-Shi, Kanagawa 252-1123 (JP); NAGATA, Takahiro, Tsukuba-shi, Ibaraki 305-0047 (JP); SANG, Liwen, Tsukuba-shi, Ibaraki 305-0047 (JP); CHIKYOW, Toyohiro, Tsukuba-shi, Ibaraki 305-0047 (JP)
(74) Representative: Novagraaf International SA
(86) International application number: PCT/JP2022/037383
(87) International publication number: WO 2023/058706

(57) **Abstract**

The present invention aims to provide at least either: a laminate comprising a silicon substrate that comprises a gallium nitride that has higher crystallinity than a laminate comprising a silicon substrate comprising conventional gallium nitride; a manufacturing method therefor; a semiconductor element comprising same; or an electronic device comprising the semiconductor element. This laminate is characterized by having a structure in which a Si (111) substrate, an oxygen-containing aluminum nitride film, and a gallium nitride film are laminated. The laminate is ideally obtained by a production method for a laminate that is characterized by having a structure in which a Si (111) substrate, an oxygen-containing aluminum nitride film, and a gallium nitride film are laminated, said production method having: an AlN film-formation step in which an aluminum nitride film is formed on the Si (111) substrate and an Si substrate comprising an aluminum nitride film is obtained; an oxidation step in which the Si substrate comprising the aluminum nitride film is treated in an oxidizing atmosphere and a Si substrate comprising an oxygen-containing aluminum nitride film is obtained; and a GaN film-formation step in which a gallium nitride film is formed on the Si substrate comprising the oxygen-containing aluminum nitride film.

## Description

### TECHNICAL FIELD

The present disclosure relates to a laminate that includes a nitride film and a silicon substrate and to a method for manufacturing the same.

### BACKGROUND ART

Nitride films such as gallium nitride (GaN) exhibit excellent semiconductor properties. Thus, investigations have been carried out to apply a laminate that includes a substrate and a nitride film to an electronic device such as a blue light-emitting diode (LED) and a blue laser diode (LD). In recent years, with the development of new applications such as power devices, a laminate that includes a silicon substrate, which is an inexpensive substrate, and a highly crystalline nitride film has been the subject of investigation.

In general, a nitride film is formed on a substrate by a film forming method such as a metal organic chemical vapor deposition (MOCVD) method or a sputtering method. Since forming a highly crystalline nitride film by a MOCVD method requires a substrate temperature of about 1000°C, what is known as melt-back etching, which is the reaction between a silicon substrate and a nitride film precursor, such as gallium, occurs during film forming. Thus, it is extremely difficult to form a highly crystalline nitride film on a silicon substrate by a MOCVD method.

Meanwhile, forming a nitride film on a silicon substrate by a sputtering method has faced difficulties in controlling the crystallinity of the nitride film. To address this, the inventors of the present invention have reported that forming an intermediate layer between a nitride film and a silicon substrate improves the crystallinity of the nitride film (Patent Document 1).

Patent Document 1: Japanese Unexamined Patent Application, Publication No. 2021-075779

### DISCLOSURE OF THE INVENTION

### Problems to be Solved by the Invention

According to Patent Document 1, the crystallinity of gallium nitride can be increased by providing a film (first thin film) made of a nitride material and/or aluminum between a silicon substrate and a gallium nitride film. However, for application to, for example, power devices, the crystallinity of gallium nitride needs to be further improved.

An object of the present disclosure is to at least provide any one of a laminate that includes a silicon substrate containing gallium nitride having higher crystallinity than a typical laminate that includes a silicon substrate containing gallium nitride, a method for manufacturing the same, a semiconductor element that includes the same, and an electronic appliance that includes the semiconductor element. Means for Solving the Problems

The inventors of the present invention have conducted investigations on a laminate that is suitable for applications such as power devices and that includes a silicon substrate and a gallium nitride film laminated thereon, more specifically, a laminate that includes a silicon substrate and a film laminated thereon with a gallium nitride film constituting the outermost surface of the laminate. As a result, the inventors have found that, by forming a particular film between the silicon substrate and the gallium nitride film, the orientation of the gallium nitride film constituting the outermost surface of the laminate exhibits high Ga polarity and thus the crystallinity of the gallium nitride film is improved. That is, the present invention is as set forth in the claims, and the gist of the present disclosure is as follows.
[1] A laminate having a structure in which a Si(111) substrate, an oxygen-containing aluminum nitride film, and a gallium nitride film are laminated.
[2] The laminate described in [1] above, in which the gallium nitride film is laminated on the oxygen-containing aluminum nitride film.
[3] The laminate described in [1] above, in which the gallium nitride film is laminated on the oxygen-containing aluminum nitride film with an aluminum nitride film therebetween.
[4] The laminate described in any one of [1] to [3] above, in which the oxygen-containing aluminum nitride film is laminated on the Si(111) substrate.
[5] The laminate described in any one of [1] to [3] above, in which the oxygen-containing aluminum nitride film is laminated on the Si(111) substrate with an aluminum film therebetween.
[6] The laminate described in any one of [1] to [5] above, in which the oxygen-containing aluminum nitride film has an oxygen content of 5 × 10²⁰ atoms/cc or more.
[7] The laminate described in any one of [1] to [6] above, in which the oxygen-containing aluminum nitride film has a thickness of 20 nm or less.
[8] The laminate described in any one of [1] to [7] above, in which a surface of the gallium nitride film has gallium polarity.
[9] A semiconductor element including the laminate described in any one of [1] to [8] above.
[10] An electronic appliance including the semiconductor element described in [9] above.
[11] A method for manufacturing a laminate having a structure in which a Si(111) substrate, an oxygen-containing aluminum nitride film, and a gallium nitride film are laminated, the method including:
   an AlN film forming step of forming an aluminum nitride film on a Si(111) substrate to obtain a Si substrate that has the aluminum nitride film;
   an oxidizing step of treating the Si substrate that has the aluminum nitride film in an oxidizing atmosphere to obtain a Si substrate that has an oxygen-containing aluminum nitride film; and
   a GaN film forming step of forming a gallium nitride film on the Si substrate that has the oxygen-containing aluminum nitride film.
[12] The method described in [11] above, in which a film forming method in the AlN film forming step is a sputtering method that involves a sputter energy of 0.01 W/cm²Pa² or more and 150 W/cm²Pa² or less.
[13] The method described in [11] or [12] above, in which an oxidizing treatment in the oxidizing step is exposure to air.
[14] The method described in any one of [11] to [13] above, in which a film forming method in the GaN film forming step is a sputtering method that involves a sputter energy of 0.01 W/cm²Pa² or more and 150 W/cm²Pa² or less.

### Effects of the Invention

The present disclosure can provide at least one of a laminate that includes a silicon substrate containing gallium nitride having higher crystallinity than a typical laminate that includes a silicon substrate containing gallium nitride, a method for manufacturing the same, a semiconductor element that includes the same, and an electronic appliance that includes the semiconductor element.

### BRIEF DESCRIPTION OF THE DRAWINGS

[Fig. 1] Fig. 1 is a schematic diagram showing a cross section of a laminate of the present embodiment.
[Fig. 2] Fig. 2 is a schematic diagram showing a cross section of a laminate of the present embodiment.
[Fig. 3] Fig. 3 is a schematic diagram showing a cross section of a laminate of the present embodiment.
[Fig. 4] Fig. 4 is a schematic diagram showing a cross section of a laminate of the present embodiment.
[Fig. 5] Fig. 5 is a pole figure of a gallium nitride film in the laminate of Example 1.
[Fig. 6] Fig. 6 is a pole figure of a gallium nitride film in the laminate of Example 2.
[Fig. 7] Fig. 7 is a pole figure of a gallium nitride film in the laminate of Example 3.
[Fig. 8] Fig. 8 is a pole figure of a gallium nitride film in the laminate of Example 4.
[Fig. 9] Fig. 9 includes pole figures of gallium nitride obtained by simulation (Fig. 9(a): Ga-polarity gallium nitride, Fig. 9(b): N-polarity gallium nitride).
[Fig. 10] Fig. 10 is a pole figure of a gallium nitride film in the laminate of Comparative Example 1.
[Fig. 11] Fig. 11 is a pole figure of a gallium nitride film in the laminate of Comparative Example 2.
[Fig. 12] Fig. 12 illustrates SIMS measurement results of the laminate of Example 2.
[Fig. 13] Fig. 13 illustrates SIMS measurement results of the laminate of Comparative Example 1.

### PREFERRED MODE FOR CARRYING OUT THE INVENTION

A laminate of the present disclosure will now be described through some exemplary embodiments.

### <Laminate>

A laminate of the present embodiment has a structure in which a Si(111) substrate, an oxygen-containing aluminum nitride film, and a gallium nitride film are laminated.

The Si(111) substrate in the laminate of the present embodiment is a silicon substrate, more specifically, a single crystal silicon substrate. The silicon substrate is known to be, for example, according to the crystal plane orientation of silicon, at least one selected from the group consisting of a Si(100) substrate, a Si(110) substrate, and a Si(111) substrate. According to the intended application, a silicon substrate having any desired crystal plane orientation can be used; however, the laminate of the present embodiment includes a Si(111) substrate since this is a silicon substrate suitable for epitaxially growing hexagonal gallium nitride.

Furthermore, the Si(111) substrate in the laminate of the present embodiment may be a silicon substrate containing a dopant and may be a silicon substrate of at least one of n-type and p-type.

The laminate of this embodiment has a structure in which a Si(111) substrate and an oxygen-containing aluminum nitride film are laminated. In this manner, a gallium nitride film having a higher orientation is formed compared with when a gallium nitride film is formed on a Si(111) substrate on which only a nitride film, such as an aluminum nitride film, substantially free of oxygen is formed.

In the present embodiment, "oxygen-containing aluminum nitride film" (hereinafter also denotable as "oxygen-containing AlN film") denotes a film that has a crystal structure of aluminum nitride (AlN) and at least one site substituted with oxygen. In other words, the composition of the oxygen-containing AlN film is deviated from the stoichiometric ratio of AlN, and the molar ratio of nitrogen (N) to aluminum (Al) is less than 1.0 (N/Al < 1.0).

The oxygen content of the oxygen-containing AlN film is preferably 5 × 10²⁰ atoms/cc or more or 7 × 10²⁰ atoms/cc or more. In this manner, the crystallinity of GaN is easy to control during film formation. The oxygen content does not have to be higher than what is necessary and is, for example, 5 × 10²¹ atoms/cc or less or 3 × 10²¹ atoms/cc or less.

The film thickness of the oxygen-containing AlN film is preferably less than 20 nm, 15 nm or less, or 10 nm or less. When the film thickness is less than 20 nm, the polarity of gallium nitride exhibits Ga polarity during the formation of the gallium nitride film, and the crystallinity tends to be high. The film thickness of the oxygen-containing AlN film is to be 0.1 nm or more or 1.0 nm or more. To form a smoother and flatter surface of the laminate of the present embodiment, the film thickness of the oxygen-containing AlN film is preferably 2.0 nm or more or 5.0 nm or more.

The oxygen-containing AlN film is preferably a thin film (oxygen-containing AlN thin film) and is more preferably a sputter-deposited film.

The oxygen-containing AlN film may be laminated on the Si(111) substrate with an aluminum film (described below) therebetween; however, for a GaN film to have higher crystallinity, the oxygen-containing AlN film is preferably laminated on the Si(111) substrate and is more preferably laminated adjacent to the Si(111) film.

The laminate of the present embodiment has a structure in which a Si(111) substrate, an oxygen-containing AlN film, and a gallium nitride film (hereinafter also denotable as "GaN film") are laminated. When a gallium nitride film is laminated on an oxygen-containing AlN film, preferably, when a gallium nitride film is laminated on a laminate having a structure in which an oxygen-containing AlN film and a Si(111) substrate are laminated, the crystallinity of gallium nitride (GaN) that constitutes the GaN film increases, and thus preferably the surface of the GaN film exhibits Ga polarity.

In the present embodiment, "gallium nitride film" denotes a film that has a crystal structure of gallium nitride and is composed of a compound containing gallium and nitrogen and that is preferably composed of gallium nitride having a hexagonal crystal structure. Furthermore, the gallium nitride film is preferably composed of gallium nitride obtained by (0002) epitaxial growth. Note that, in the present embodiment, (0002) epitaxial growth can be confirmed by examining whether gallium nitride has Ga polarity or N polarity.

The film thickness of the GaN film is preferably 10 nm or more, 30 nm or more, or 50 nm or more. In addition, the film thickness of the GaN film is, for example, 1000 nm or less, 500 nm or less, 300 nm or less, or 100 nm or less.

The GaN film is preferably a thin film (GaN thin film) and more preferably a sputter-deposited film.

The GaN film may be laminated on the oxygen-containing AlN film with an aluminum nitride film (described below) therebetween; however, for a GaN film to have higher crystallinity, the GaN film is preferably laminated on the oxygen-containing AlN film and is more preferably laminated adjacent to the oxygen-containing Al film.

The laminate of the present embodiment may include, in addition to the oxygen-containing AlN film and the GaN film, at least one of an aluminum nitride film (hereinafter also denotable as "AlN film") and an aluminum film (hereinafter also denotable as "Al film"). By forming an AlN film, a GaN film having higher crystallinity can be easily obtained. Moreover, when an Al film is formed, the oxygen-containing AlN film or an AlN film laminated on the Al film tends to exhibit improved crystallinity.

The AlN film is a film of aluminum nitride and is an aluminum nitride film having a crystal structure of aluminum nitride without being substituted with oxygen. The composition of the AlN film may deviate from the stoichiometric ratio of AlN, and the Al:N molar ratio does not have to be 1:1.

AlN is substantially free of oxygen. The oxygen content of the AlN film (the AlN film other than the oxidized AlN film) is, for example, less than 5 × 10²⁰ atoms/cc or 7 × 10²⁰ atoms/cc or less.

The film thickness of the AlN film may be any thickness and is, for example, 0.1 nm or more or 1.0 nm or more, and less than 20 nm, 15 nm or less, or 10 nm or less.

The AlN film is preferably laminated on the oxygen-containing AlN film.

The Al film is a film composed of metallic aluminum. The Al film is preferably laminated on the Si(111) substrate.

The laminate of the present embodiment is a laminate in which the Si(111) substrate, the oxygen-containing AlN film, and the gallium nitride film are laminated and may be considered a substrate-film laminate or a laminate film structure.

The laminate of the present embodiment preferably includes a Si(111) substrate, an oxygen-containing AlN film, and a GaN film laminated in this order and preferably has a structure in which the oxygen-containing AlN film is laminated adjacent to the Si(111) substrate and the GaN film is laminated adjacent to the oxygen-containing AlN film. The laminate of the present embodiment is to include various films sequentially stacked on the Si(111) substrate, and the surface (specifically, the surface opposing the Si(111) substrate or the outermost surface) of the laminate is to be the GaN film. Multiple oxygen-containing AlN films and GaN films may be stacked on the Si(111) substrate.

The laminate of the present embodiment will now be described on the basis of the structure illustrated in the following drawings. In the following drawings, the Si(111) substrate, the oxygen-containing AlN film, the GaN film, the AlN film, and the Al film are schematically illustrated as having approximately the same thickness (film thickness); however, they may have different thicknesses.

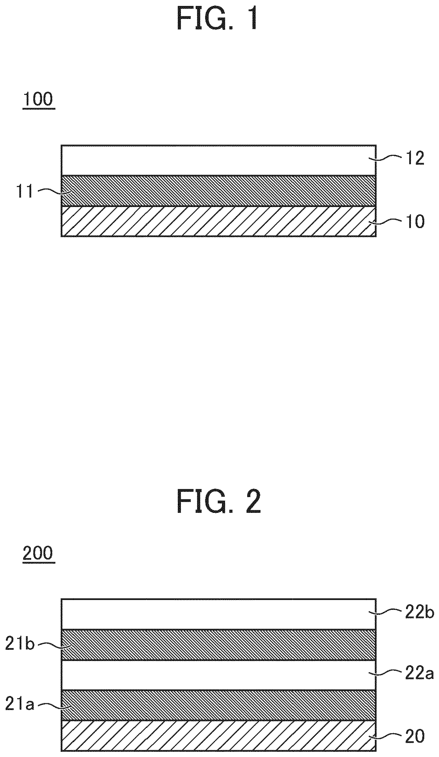

Fig. 1 is a schematic diagram showing a cross section of the laminate of the present embodiment. The laminate (100) has a structure in which a Si(111) substrate (10), an oxygen-containing AlN film (11), and a GaN film (12) are laminated. In the laminate (100), the oxygen-containing AlN film (11) is laminated on the Si(111) substrate (10), and the GaN film (12) is laminated on the oxygen-containing AlN film (11).

Fig. 2 is a schematic diagram showing a cross section of a laminate according to another embodiment. The laminate (200) has a structure in which a Si(111) substrate (20), two oxygen-containing AlN films (21a and 21b), and two GaN films (22a and 22b) are laminated. In the laminate (200), the oxygen-containing AlN film (21a) is laminated on the Si(111) substrate (20), the GaN film (22a) is laminated on the oxygen-containing AlN film (21a), the oxygen-containing AlN film (21b) is laminated on the GaN film (22a), and the GaN film (22b) is laminated on the oxygen-containing AlN film (21b). As such, stress generated in the laminate is likely to be relaxed by stacking multiple GaN films.

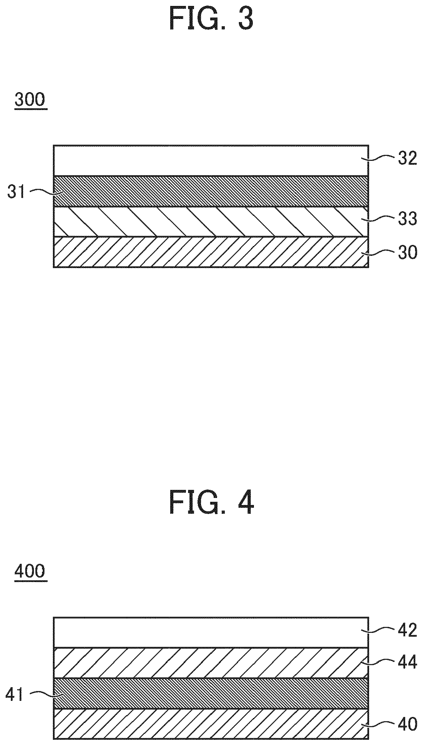

Fig. 3 is a schematic diagram showing a cross section of a laminate according to another embodiment. The laminate (300) has a structure in which a Si(111) substrate (30), an oxygen-containing AlN film (31), a GaN film (32), and an Al film (33) are laminated. In the laminate (300), the Al film (33) is laminated on the Si(111) substrate (30), the oxygen-containing AlN film (31) is laminated on the Al film (33), and the GaN film (32) is laminated on the oxygen-containing AlN film (31). As such, a GaN film having Ga polarity is likely to grow by the oxygen-containing AlN film being laminated on the Al film.

Fig. 4 is a schematic diagram showing a cross section of a laminate according to another embodiment. The laminate (400) has a structure in which a Si(111) substrate (40), an oxygen-containing AlN film (41), an AlN film (44), and a GaN film (42) are laminated. In the laminate (400), the oxygen-containing AlN film (41) is laminated on the Si(111) substrate (40), the AlN film (44) is laminated on the oxygen-containing AlN film (41), and the GaN film (42) is laminated on the AlN film (44). Even with a structure in which the GaN film is not directly laminated on the oxygen-containing AlN film, a highly crystalline GaN film can be formed due to the structure in which the AlN film is laminated on the oxygen-containing AlN film.

### <Semiconductor element and electronic appliance>

The laminate of the present embodiment can also be incorporated in a semiconductor element and used. The semiconductor element of the present embodiment can also be incorporated in an electronic appliance and used.

The semiconductor element that includes the laminate of the present embodiment (hereinafter also denotable as "semiconductor element of the present embodiment") can be used in known semiconductor element applications and can be preferably used as at least one of a light-emitting element and a power device, and more preferably as a power device. An example of the light-emitting element is at least one of a blue light-emitting diode (LED) and a blue laser diode (LD). In addition, an example of application as a power device is a semiconductor element used in controlling and supplying electrical energy, such as at least one of a diode and a transistor.

The semiconductor element of the present embodiment may have a structure in which the laminate of the present embodiment is included as a base layer and in which films of a nitride, such as gallium nitride (GaN), are laminated on the laminate.

### <Method for manufacturing the laminate>

The laminate of the present embodiment can be manufactured by any method as long as a laminate that satisfies the aforementioned structure is obtained. A preferable example of the manufacturing method of the present embodiment (hereinafter also denotable as "manufacturing method of the present embodiment") is a method for manufacturing a laminate that has a structure in which a Si(111) substrate, an oxygen-containing aluminum nitride film, and a gallium nitride film are laminated, the method including:
an AlN film forming step of forming an aluminum nitride film on a Si(111) substrate to obtain a Si substrate that has the aluminum nitride film;
an oxidizing step of treating the Si substrate that has the aluminum nitride film in an oxidizing atmosphere to obtain a Si substrate that has an oxygen-containing aluminum nitride film; and
a GaN film forming step of forming a gallium nitride film on the Si substrate that has the oxygen-containing aluminum nitride film.

In the AlN film forming step, an AlN film is formed on a Si(111) substrate to obtain a Si substrate that has an AlN film.

The Si(111) substrate used in the AlN film forming step may be any known Si(111) substrate and preferably has a surface roughness (Ra) of 0.5 nm or less and more preferably 0.3 nm or less. Examples of the known Si(111) substrate include Si(111) substrates manufactured by a Czochralski (CZ) method or a floating zone (FZ) method and Si(111) substrates manufactured by epitaxially growing Si single crystal layers on Si single crystal substrates.

The manufacturing method of the present embodiment may include a washing step of washing the Si(111) substrate prior to the AlN film forming step. Washing may involve any known washing method with which impurities on the Si(111) substrate can be removed, and an example thereof is a washing method that involves immersing the Si(111) substrate in a washing solution, i.e., wet etching.

The washing solution is preferably at least one selected from the group consisting of an aqueous hydrofluoric acid solution, sulfuric acid, hydrochloric acid, hydrogen peroxide, ammonium hydroxide, trichloroethylene, acetone, methanol, and isopropanol and is more preferably an aqueous hydrofluoric acid solution. To remove the impurities on the Si(111) substrate and reduce the surface roughness of the Si(111) substrate, the washing solution is preferably an aqueous hydrofluoric acid solution having a hydrofluoric acid concentration of 5 mass% or more and 10 mass% or less.

Immersing may involve placing the Si(111) substrate in the washing solution such that the substrate is immersed in the washing solution. Immersing may be carried out in at least one of a stationary state and an agitated state and may be carried out in an agitated state created by ultrasonic vibrations by using an ultrasonic washer, for example.

The immersing time may be appropriately adjusted according to the type and concentration of the washing solution and may be, for example, 5 seconds or longer and 100 seconds or shorter.

The remaining washing solution on the Si(111) substrate after washing may be removed by any desired method. The method for removing the washing solution may be any method and may involve, for example, spraying an inert gas (for example, at least one of a nitrogen gas and an argon gas) onto the Si(111) substrate.

In the AlN film forming step, an AlN film is formed on a Si(111) substrate. The film forming method is preferably a sputtering method. A specific example of the sputtering method is at least one selected from the group consisting of a DC sputtering method, an RF sputtering method, an AC sputtering method, a DC magnetron sputtering method, an RF magnetron sputtering method, a pulsed sputtering method, and an ion beam sputtering method. Since a film can be formed on a large-area substrate in a short period of time, the sputtering method is preferably at least one of a DC magnetron sputtering method and an RF magnetron sputtering method and is more preferably a DC magnetron sputtering method.

A known target used in forming AlN films may be used as the sputtering target (hereinafter also simply denotable as "target") in the sputtering method. An example of such a target is at least one selected from the group consisting of an aluminum target and an aluminum nitride target and is preferably an aluminum target.

From the viewpoint of increasing the crystallinity of the film, the target preferably has a low oxygen content, and the oxygen content of the target is preferably 3 ato (atomic %) or less and more preferably 1 at% or less. The oxygen content of the target is, for example, 0.1 at% or more.

The area of the sputtering surface of the target is more preferably 18 cm² or more since the evenness of the film thickness and film quality of the AlN film to be obtained tends to be improved. The larger the area of the sputtering surface, the easier it is to obtain a large laminate; however, the area of the sputtering surface is, for example, 3000 cm² or less. Here, "sputtering surface" denotes a surface that faces an article, such as a substrate, on which a film is to be formed during sputtering and that comes into contact with a plasmanized atmospheric gas.

To reduce the decrease in the crystallinity of the AlN film to be obtained, the sputtering preferably starts in a vacuum atmosphere where the degree of vacuum attained is 1 × 10⁻⁴ Pa or less, 7 × 10⁻⁵ Pa or less, 2 × 10⁻⁵ Pa or less, 9 × 10⁻⁶ Pa or less, or 5 × 10⁻⁶ Pa or less.

To control the sputtering atmosphere, an introduced gas is used during the sputtering. Thus, the pressure during the sputtering is higher than that at the start of the sputtering. The pressure during the sputtering is, for example, 0.1 Pa or more and 0.8 Pa or less.

To promote migration of the sputtering particles, the sputtering is preferably conducted while heating the substrate. The substrate temperature, that is, the temperature of the substrate during sputtering, is 100°C or higher or 600°C or higher and is preferably 800°C or lower or 700°C or lower.

The sputtering time changes depending on the sputtering apparatus to be used but is preferably a period of time with which the film thickness of the AlN film obtained is 4 nm or more and 20 nm or less. For example, sputtering may be carried out for any desired period of time to measure the film thickness of the obtained AlN film and to determine the sputtering time required for forming a film having a unit film thickness (nm), and the sputtering time may then be set to achieve the desired film thickness on the basis of the outcome.

The sputtering atmosphere may be any known atmosphere used in sputter-deposition of AlN films and may be, for example, at least one selected from the group consisting of an argon atmosphere, a nitrogen atmosphere, and an argon/nitrogen atmosphere. The introduced gas for creating such a sputtering atmosphere may be any known gas used in forming AlN films. The introduced gas may be at least one of a mixed gas of argon (Ar) and nitrogen (N₂) and a nitrogen gas and may be a mixed gas of argon and nitrogen. In addition, other gases such as an oxygen gas and ammonia may be introduced as necessary.

An example of the preferable sputtering method is a method that involves forming an Al film having a film thickness of 1 nm or more and 10 nm or less in an argon atmosphere and then nitriding the Al film and simultaneously forming an AlN film in a nitrogen-containing atmosphere. In this manner, a highly crystalline AlN film is easily obtained.

In addition, an example of the preferable film forming method is a sputtering method that involves a sputter energy of 0.01 W/cm²Pa² or more and 150 W/cm²Pa² or less. The sputtering energy is preferably 0.1 W/cm²Pa² or more, 0.5 W/cm²Pa² or more, 1 W/cm²Pa² or more, or 2 W/cm²Pa² or more and may be 100 W/cm²Pa² or less, 60 W/cm²Pa² or less, or 30 W/cm²Pa² or less.

In the present embodiment, the sputter energy (Es) is the energy of the sputter particles during sputtering and can be determined from the following equation:

Es = [injected power density (unit: W/cm²)]/[introduced gas pressure (unit: Pa)]²

The injected power density in the aforementioned equation is the injection energy per unit area of the sputtering surface determined by dividing the actual injected power by the area of the sputtering surface.

Prior to sputtering, to remove the remaining gas remaining in the sputtering apparatus, the sputtering apparatus may be baked.

### <Oxidizing step>

In the oxidizing step, the Si(111) substrate that has the aluminum nitride film is treated in an oxidizing atmosphere to obtain a Si(111) substrate that has an oxygen-containing aluminum nitride film.

The treatment in the oxidizing atmosphere may be conducted under any conditions that allow the aluminum nitride film to partially capture oxygen. An example of such a treatment is exposure to air.

The exposure time is not limited and is, for example, 10 seconds or longer and 5 minutes or shorter.

In the manufacturing method of the present embodiment, the obtained laminate may be subjected to an AlN film forming step after the oxidizing step and before the GaN film forming step.

### <GaN film forming step>

In the GaN film forming step, a GaN film is formed on the Si(111) substrate that has the oxygen-containing AlN film. The film forming method is preferably a sputtering method.

A specific example of the sputtering method is at least one selected from the group consisting of a DC sputtering method, an RF sputtering method, an AC sputtering method, a DC magnetron sputtering method, an RF magnetron sputtering method, a pulsed sputtering method, and an ion beam sputtering method. Since a film can be formed on a large-area substrate in a short period of time, the sputtering method is preferably at least one of a DC magnetron sputtering method and an RF magnetron sputtering method and is more preferably a DC magnetron sputtering method.

A known target used in forming GaN films may be used as the target. An example of such a target is at least one selected from the group consisting of a gallium target and a gallium nitride target and is preferably a GaN target.

From the viewpoint of increasing the crystallinity of the film, the target preferably has a low oxygen content, and the oxygen content of the target is preferably 3 ato (atomic %) or less and more preferably 1 at% or less. The oxygen content of the target is, for example, 0.1 at% or more.

The area of the sputtering surface of the target is more preferably 18 cm² or more since the evenness of the film thickness and film quality of the GaN film to be obtained tends to be improved. The larger the area of the sputtering surface, the easier it is to obtain a large laminate; however, the area of the sputtering surface is, for example, 3000 cm² or less. Here, "sputtering surface" denotes a surface that faces an article, such as a substrate, on which a film is to be formed during sputtering and that comes into contact with a plasmanized atmospheric gas.

To reduce the decrease in the crystallinity of the GaN film to be obtained, the sputtering is preferably carried out at an attained degree of vacuum of 1 × 10⁻⁴ Pa or less, 7 × 10⁻⁵ Pa or less, 2 × 10⁻⁵ Pa or less, 9 × 10⁻⁶ Pa or less, or 5 × 10⁻⁶ Pa or less.

To control the sputtering atmosphere, an introduced gas is used during the sputtering. Thus, the pressure during the sputtering is higher than that at the start of the sputtering. The pressure during the sputtering is, for example, 0.1 Pa or more and 0.8 Pa or less.

To promote migration of the sputtering particles, the sputtering is preferably conducted while heating the substrate. The substrate temperature, that is, the temperature of the substrate during sputtering, is 100°C or higher or 600°C or higher and is preferably 800°C or lower or 700°C or lower. The obtained film becomes flat and smooth and tends to have higher crystallinity.

The sputtering time changes depending on the sputtering apparatus used and may be sufficient for forming a GaN film having a desired film thickness, for example, 5 seconds or longer and 1200 minutes or shorter.

The sputtering atmosphere may be any known atmosphere used in sputter-deposition of GaN films and may be, for example, at least one selected from the group consisting of an argon atmosphere, a nitrogen atmosphere, and an argon/nitrogen atmosphere. The introduced gas for creating such a sputtering atmosphere may be any known gas used in forming a GaN film. The introduced gas may be at least one of a mixed gas of argon (Ar) and nitrogen (N₂) and a nitrogen gas and may be a mixed gas of argon and nitrogen. In addition, other gases such as an oxygen gas and ammonia may be introduced as necessary.

In addition, an example of the preferable film forming method is a sputtering method that involves a sputter energy of 0.01 W/cm²Pa² or more and 150 W/cm²Pa² or less. The sputtering energy is preferably 0.1 W/cm²Pa² or more, 0.5 W/cm²Pa² or more, 1 W/cm²Pa² or more, or 2 W/cm²Pa² or more, and may be 100 W/cm²Pa² or less, 60 W/cm²Pa² or less, or 30 W/cm²Pa² or less.

### <Other steps>

In the manufacturing method of the present embodiment, the AlN film forming step, the oxidizing step, and the GaN film forming step may be repeated, for example, twice or more and five times or less.

Furthermore, the laminate obtained by the manufacturing method of the present embodiment may be subjected to a method, for example, a MOCVD method, other than the sputtering method to form a gallium nitride film. Although the embodiments of the present disclosure are described above, the present disclosure is not limited to these embodiments, and any numerical range obtained by freely combining an upper limit and a lower limit specifically disclosed in these embodiments is also included in the present disclosure. In addition, the upper limit and/or the lower limit may be replaced by a value in Examples described below, and such a range is also included in the present disclosure.

### EXAMPLES

The present embodiments will now be further described by using Examples and Comparative Examples. However, the present embodiments are not limited by the Examples described below. The laminates obtained were evaluated for the following features.

### <Oxygen content>

The oxygen content was measured by secondary ion mass spectrometry (SIMS ; SECONDARY ION MAS SPECTROMETRY). That is, a quadrupole secondary ion mass spectrometer was used to measure the secondary ion intensities of Si, Al, Ga, and oxygen (O) under the following conditions.

Cs ion source: 1 kV
Primary ion current: 100 nA
Degree of vacuum in chamber: 5 × 10⁻¹⁰ torr

The obtained secondary ion intensities were compared with the secondary ion intensities of standard samples, and the content of each element was determined. In the SIMS measurement results, a secondary ion intensity peak of oxygen (O) overlapping the secondary ion intensity peak of Al and exhibiting the highest intensity was assumed to be the secondary ion intensity peak corresponding to oxygen in the oxygen-containing AlN film, and the oxygen content thereof was determined.

### <Film thickness>

A step meter (apparatus name: DekTak 6M produced by Bruker Japan) was used to measure the film thickness of each film in the laminate. The vertical resolution for measurement was set to 0.1 nm.

### <Polarity and crystallinity of gallium nitride thin film>

A time-of-flight atom scattering surface analyzer (instrument name: TOFLAS-3000 produced by Pascal Co., Ltd.) was used to evaluate the polarity and crystal phase of the GaN film. The pole figure was measured under the following conditions by placing the laminate in the instrument such that the film-deposited surface (the surface on which the GaN film was formed) of the laminate faced upward.

Probe: He (atom scattering)
Energy: 3 keV
Beam source-to-target distance: 805 mm
Target-to-detector distance: 395 mm
Degree of vacuum in analysis chamber: 2 × 10⁻³ Pa or less

The obtained pole figure was compared with a pole figure of the crystal phase and polarity of each of the layers corresponding to the four atomic layers from the outermost surface of the GaN film simulated by using a bundled analyzer of the aforementioned instrument so as to confirm the polarity and crystal phase of the GaN film in the laminate.

### Example 1

An n-type Si(111) substrate (produced by MATSUZAKI SEISAKUSYO CO., LTD., off-angle: none, diameter: 50±0.5 mm, thickness: 425±25 µm, resistivity: 1000Ω·cm or more) was used as the silicon substrate.

Ultrapure water (produced by Kanto Chemical Co., Inc., ultrapure grade) was used to dilute hydrofluoric acid (produced by Kanto Chemical Co., Inc., ultrapure grade) to obtain diluted hydrofluoric acid having a hydrofluoric acid concentration of 5 mass%. The Si substrate was immersed in the obtained diluted hydrofluoric acid for 30 seconds to be wet-etched, and the silicon substrate was then recovered. A nitrogen gas was sprayed onto the recovered Si substrate to remove droplets on the surface of the silicon substrate to obtain a silicon substrate having a surface roughness (Ra) of 0.15 nm.

### <AlN film forming and oxidizing treatment>

Next, an AlN film was formed on the silicon substrate by using a magnetron sputtering machine by an RF magnetron sputtering method.

Film forming involved placing a metallic aluminum (Al) target (purity: 99.99 mass%) and the silicon substrate in a film deposition chamber (chamber) of the magnetron sputtering machine and then decreasing the pressure inside the film deposition chamber. After the degree of vacuum had reached 1.9 × 10⁻⁶ Pa, sputtering under the following conditions was started in an argon atmosphere to obtain a laminate (Al/silicon substrate laminate) that had a 1.5 nm-thick Al film on the silicon substrate.

Introduced gas: argon
Introduced gas flow rate: 20 sccm
Substrate temperature: 400°C
Pressure: 0.5 Pa
Sputter energy (Es): 30 W/cm²Pa²
Sputtering time: 10 seconds

After the film was formed as described above, the atmosphere was switched to an argon/nitrogen atmosphere, and, in this atmosphere, the Al film was nitrided and simultaneously a 4 nm-thick AlN film was formed on the Al film by sputtering under the following conditions to thereby form a laminate (AlN/silicon substrate laminate) that included a silicon substrate having a 5.5 nm-thick AlN film.

Introduced gas: argon and nitrogen
Introduced gas flow rate: argon: 16 sccm, nitrogen: 4 sccm
Substrate temperature: 650°C
Pressure: 0.5 Pa
Sputter energy (Es): 30 W/cm²Pa²
Sputtering time: 60 seconds

The Si substrate after the film forming was moved from the film deposition chamber to a preparation chamber (load-lock chamber), and the preparation chamber was then released to air for 1 minute to expose the AlN/silicon substrate laminate to air. After the exposure to air, the preparation chamber was depressurized, and, after the degree of vacuum had reached 1.9 × 10⁻⁶ Pa, sputtering was resumed. Sputtering was conducted under the same aforementioned conditions except that the sputtering time was changed to 120 seconds in an argon/nitrogen atmosphere. As a result, another AlN film having a thickness of 8 nm was formed to obtain a laminate (AlN/oxygen-containing AlN/silicon substrate laminate) that included a silicon substrate that had a 8 nm-thick AlN film on the 5.5 nm-thick oxygen-containing AlN film.

### <GaN film forming>

Sputtering was performed under the same method as for the first thin film except that the obtained laminate (AlN/oxygen-containing AlN/silicon substrate laminate) was used, that a gallium nitride (GaN) target (purity: 99.99 mass%) was used as the sputtering target, and that the sputtering conditions were changed to the following conditions, so as to form a 70 nm-thick GaN film on the AlN film.

Introduced gas: argon and nitrogen
Introduced gas flow rate: argon: 16 sccm, nitrogen: 4 sccm
Substrate temperature: 650°C
Pressure: 1.0 Pa
Sputter energy (Es): 20 W/cm²Pa²
Film deposition time: 17 minutes

As a result, a laminate (GaN/AlN/oxygen-containing AlN/silicon substrate laminate) in which a silicon substrate, an oxygen-containing AlN film (film thickness: 5.5 nm), an AlN film (film thickness: 8 nm), and a GaN film (film thickness: 70 nm) were laminated was obtained, and was used as the laminate of this example.

### Example 2

A 12 nm-thick AlN film was formed as in Example 1 except that, in forming the AlN film, the sputtering time was changed to 180 seconds, so as to obtain a laminate (AlN/silicon substrate laminate) that included a Si substrate having a 13.5 nm-thick AlN film.

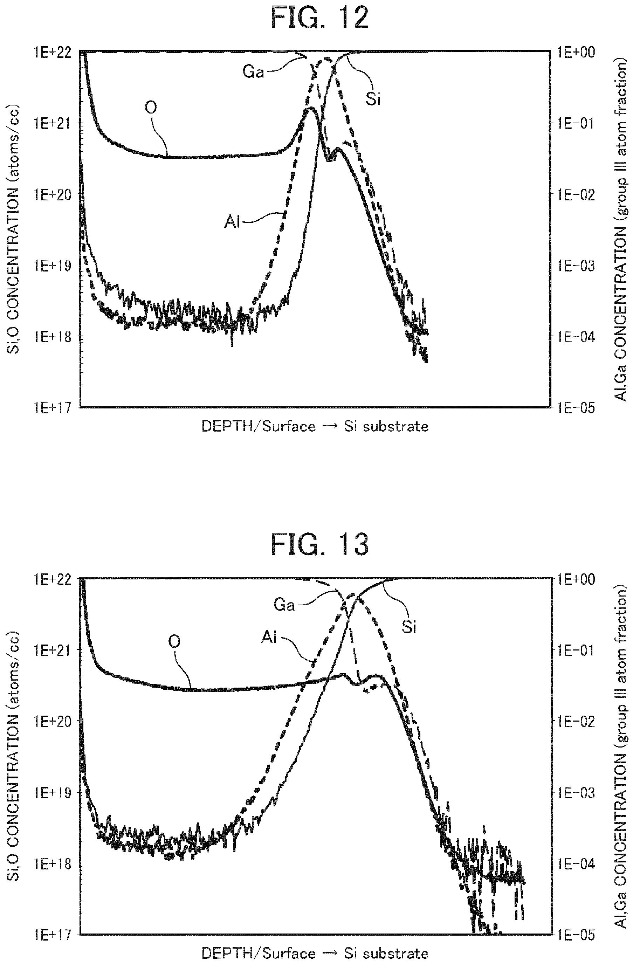

Exposure to air and formation of a GaN film were conducted as in Example 1 except that the obtained AlN/silicon substrate laminate was used, so as to obtain a laminate (GaN/oxygen-containing AlN/silicon substrate laminate) in which a silicon substrate, an oxygen-containing AlN film (film thickness: 13.5 nm), and a GaN film (film thickness: 70 nm) were laminated, and this laminate was used as the laminate of this example. The SIMS measurement results of the laminate of this example are illustrated in Fig. 12.

### Example 3

An AlN film and a GaN film were formed as in Example 1 except that a laminate (GaN/oxygen-containing AlN/silicon substrate laminate) in which a silicon substrate, an oxygen-containing AlN film (film thickness: 5.5 nm), an AlN film (film thickness: 8 nm), and a GaN film (film thickness: 70 nm) were laminated obtained as in Example 1 was used, so as to obtain a laminate (GaN/AlN/oxygen-containing AlN/GaN/AlN/oxygen-containing AlN/silicon substrate laminate) in which a silicon substrate, an oxygen-containing AlN film (film thickness: 5.5 nm), an AlN film (film thickness: 8 nm), an GaN film (film thickness: 70 nm), an oxygen-containing AlN film (film thickness: 5.5 nm), an AlN film (film thickness: 8 nm), and a GaN film (film thickness: 70 nm) were laminated. This laminate was used as the laminate of this example.

### Example 4

An AlN film and a GaN film were formed as in Example 2 except that a laminate (GaN/oxygen-containing AlN/Si laminate) in which a silicon substrate, an oxygen-containing AlN film (film thickness: 13.5 nm), and a GaN film (film thickness: 70 nm) were laminated obtained as in Example 2 was used, so as to obtain a laminate (GaN/oxygen-containing AlN/GaN/oxygen-containing AlN/silicon substrate laminate) in which a Si substrate, an oxygen-containing AlN film (film thickness: 13.5 nm), a GaN film (film thickness: 70 nm), an oxygen-containing AlN film (film thickness: 13.5 nm), and a GaN film (film thickness: 70 nm) were laminated. This laminate was used as the laminate of this example.

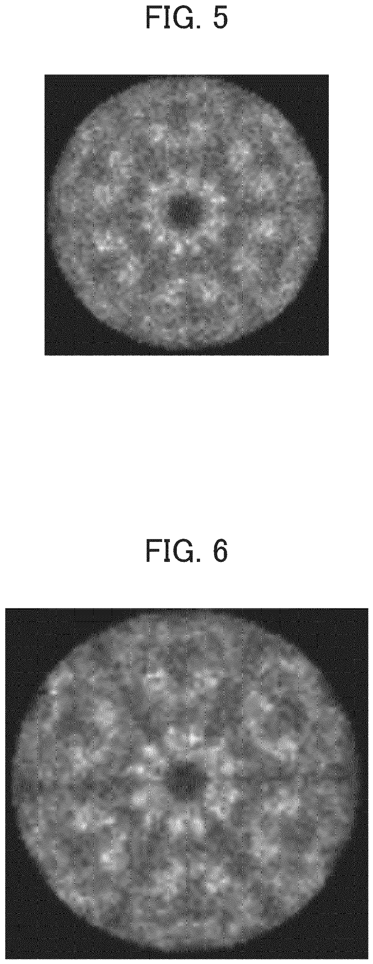

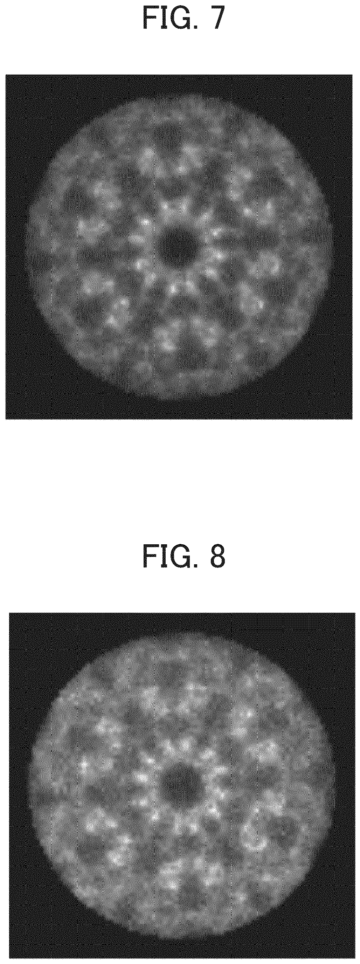

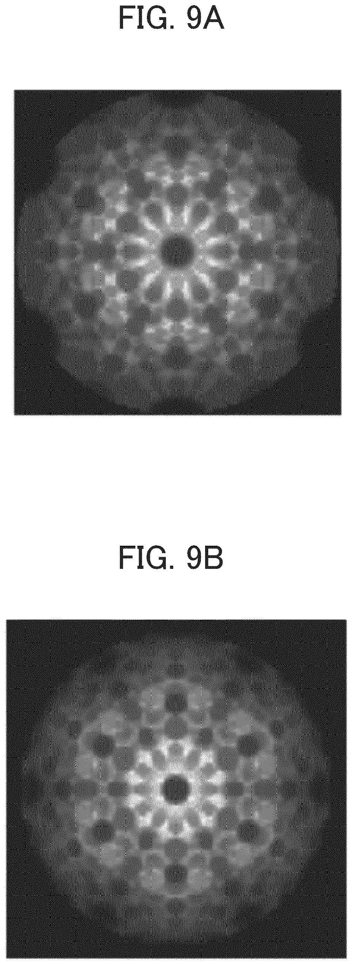

The pole figures of the surfaces of the GaN films in the laminates of these examples are illustrated in Figs. 5 to 8. Since the simulation pattern of the Ga-polarity GaN illustrated in Fig. 9(a) and the pattern of the pole figure of the Gan film in the laminate of each example were the same, it could be confirmed that the surface of the GaN film had Ga polarity and that the GaN film of each Example was composed of (0002) epitaxially grown GaN.

### Comparative Example 1

A laminate (GaN/AlN/silicon substrate laminate) in which a Si substrate, an AlN film (film thickness: 13.5 nm), and a GaN film (film thickness: 70 nm) were laminated was obtained as in Example 1 except that exposure to air was omitted after formation of the AlN film, and was used as the laminate of this comparative example. The SIMS measurement results of the laminate of this comparative example are illustrated in Fig. 13.

### Comparative Example 2

A laminate (GaN/AlN/silicon substrate laminate) in which a Si substrate, an AlN film (film thickness: 13.5 nm), and a GaN film (film thickness: 70 nm) were laminated was obtained as in Example 2 except that exposure to air was omitted after formation of the AlN film. An AlN film and a GaN film were again formed by using the obtained laminate so as to obtain a laminate (GaN/AlN/GaN/AlN/silicon substrate laminate) in which a silicon substrate, an AlN film (film thickness: 13.5 nm), a GaN film (film thickness: 70 nm), an AlN film (film thickness: 13.5 nm), and a GaN film (film thickness: 70 nm) were laminated, and was used as the laminate of this comparative example.

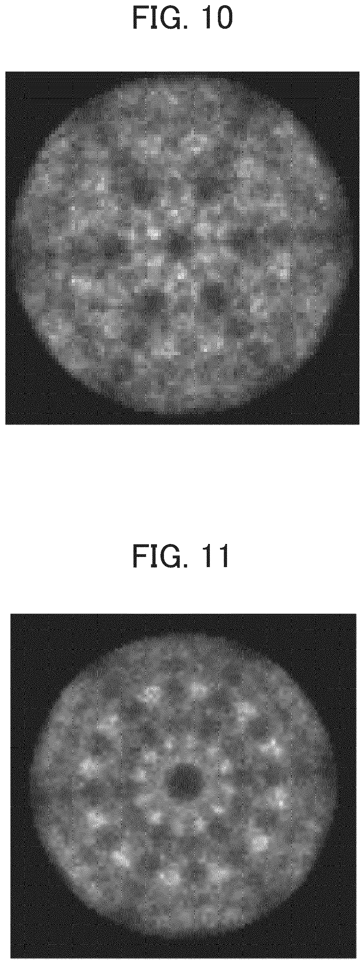

The pole figures of the surfaces of the GaN films in the laminates of these comparative examples are illustrated in Figs. 10 to 11. Since the simulation pattern (Fig. 9(b)) of N-polarity GaN and the pattern of the pole figure of Comparative Example 2 are the same, it could be confirmed that the surface of the GaN film had N polarity. Meanwhile, the pattern of the pole figure of Comparative Example 1 was different from any simulation pattern and was confirmed to lack Ga polarity.

The results are illustrated in the table below.

**[Table 1]**

| | Oxygen-containing AlN film | | GaN film (outermost surface) |
|---|---|---|---|
| | Film thickness [nm] | Oxygen content [atoms/cc] | Polarity |
| Example 1 | 5.5 | 2.0×10^21 | Ga |
| Example 2 | 13.5 | 1.6×10^21 | Ga |
| Example 3 | 5.5 | - | Ga |
| Example 4 | 13.5 | - | Ga |
| Comparative Example 1 | 13.5 | 4.4×10^20 | none |
| Comparative Example 2 | 13.5 | - | N |

The entire contents of the description, the claims, the drawings, and the abstract of Japanese Patent Application No. 2021-166428 filed in the Japan Patent Office on October 8, 2021 are incorporated herein as the disclosure of the description of the present disclosure by reference.

### EXPLANATION OF REFERENCE NUMERALS

100, 200, 300, 400 laminate of the present embodiment
10, 20, 30, 40 Si(111) substrate
11, 21a, 21b, 31, 41 oxygen-containing AlN film
12, 22a, 22b, 32, 42 GaN film
33 Al film
44 AlN film

## Claims

1. A laminate comprising a structure in which a Si(111) substrate, an oxygen-containing aluminum nitride film, and a gallium nitride film are laminated.

2. The laminate according to Claim 1, wherein the gallium nitride film is laminated on the oxygen-containing aluminum nitride film.

3. The laminate according to Claim 1, wherein the gallium nitride film is laminated on the oxygen-containing aluminum nitride film with an aluminum nitride film therebetween.

4. The laminate according to any one of Claims 1 to 3, wherein the oxygen-containing aluminum nitride film is laminated on the Si(111) substrate.

5. The laminate according to any one of Claims 1 to 3, wherein the oxygen-containing aluminum nitride film is laminated on the Si(111) substrate with an aluminum film therebetween.

6. The laminate according to any one of Claims 1 to 5, wherein the oxygen-containing aluminum nitride film has an oxygen content of 5 × 10²⁰ atoms/cc or more.

7. The laminate according to any one of Claims 1 to 6, wherein the oxygen-containing aluminum nitride film has a thickness of 20 nm or less.

8. The laminate according to any one of Claims 1 to 7, wherein a surface of the gallium nitride film has gallium polarity.

9. A semiconductor element comprising the laminate according to any one of Claims 1 to 8.

10. An electronic appliance comprising the semiconductor element according to Claim 9.

11. A method for manufacturing a laminate having a structure in which a Si(111) substrate, an oxygen-containing aluminum nitride film, and a gallium nitride film are laminated, the method comprising:
an AlN film forming step of forming an aluminum nitride film on a Si(111) substrate to obtain a Si substrate that has the aluminum nitride film;
an oxidizing step of treating the Si substrate that has the aluminum nitride film in an oxidizing atmosphere to obtain a Si substrate that has an oxygen-containing aluminum nitride film; and
a GaN film forming step of forming a gallium nitride film on the Si substrate that has the oxygen-containing aluminum nitride film.

12. The method according to Claim 11, wherein a film forming method in the AlN film forming step is a sputtering method that involves a sputter energy of 0.01 W/cm²Pa² or more and 150 W/cm²Pa² or less.

13. The method according to Claim 11 or 12, wherein an oxidizing treatment in the oxidizing step is exposure to air.

14. The method according to any one of Claims 11 to 13, wherein a film forming method in the GaN film forming step is a sputtering method that involves a sputter energy of 0.01 W/cm²Pa² or more and 150 W/cm²Pa² or less.
